# EUROPÄISCHE PATENTANMELDUNG

(11) **EP 0 812 018 A1**
(43) Veröffentlichungstag der Anmeldung: **10.12.1997**
(21) Anmeldenummer: 97109024.6
(22) Anmeldetag: 04.06.1997
(51) Int. Cl.: H01L 27/092, H01L 21/768

(54) **CMOS-Halbleiterstruktur mit Feldplatten und selbstjustiertem Kontakt sowie deren Herstellungsverfahren**

(30) Priorität: 04.06.1996 DE 19622415
(71) Anmelder: SIEMENS AKTIENGESELLSCHAFT, 80333 München (DE)
(72) Erfinder: Kerber, Martin, Dr. rer. nat., 81827 München (DE)

(57) **Zusammenfassung**

Mit der Erfindung wird eine CMOS-Halbleiterstruktur und ein Verfahren zur Herstellung dieser Struktur geschaffen, mit dem eine besonders einfache selbstjustierte Kontaktlochätzung möglich ist. Dabei werden Feldplatten 12 und 13 von einer Nitridschicht 4 und einer seitlichen Abdeckung 14 vollständig ummantelt, so daß die Feldplatten auch bei einer verjustierten Kontaktlochätzung geschützt sind. Zur Herstellung dieser Struktur werden die aus einer Polysiliziumschicht gebildeten Feldplatten durch eine isotrope Ätzung lateral rückgeätzt und eine dielektrische Schicht konform abgeschieden und damit der rückgeätzte Feldplattenbereich gefüllt. Die dielektrische Schicht wird dann durch eine isotrope Ätzung außerhalb der rückgeätzten Feldplattenbereiche wieder entfernt.

## Beschreibung

Die Erfindung betrifft eine CMOS-Halbleiterstruktur mit einem Substrat, einem Gateoxid, einer darüberliegenden Polysiliziumschicht zur Bildung von Feldplatten und weiteren, darüberliegenden Schichten, insbesondere einer Oxidschicht. Weiterhin betrifft die Erfindung ein Verfahren zur Herstellung einer solchen CMOS-Halbleiterstruktur, bei dem auf einem Substrat, ein Gateoxid erzeugt wird, eine Polysiliziumschicht, eine Nitridschicht und eine Oxidschicht abgeschieden werden und eine durch eine Fototechnik maskierte anisotrope Ätzung bis zum Gateoxid durchgeführt wird.

Bei der Herstellung von integrierten CMOS-Schaltkreisen entfällt ein beträchtlicher Flächenanteil auf die elektrischen Kontakte zwischen den Source- und Draingebieten der Transistoren und der ersten Metallebene. Der Flächenbedarf kommt einmal durch die Minimalgröße eines Loches zustande und andererseits durch Minimalabstände zu den Strukturkanten von Feldoxid und Gateelektrode und anderen Strukturen. Die zwischen diesen Strukturen einzuhaltenden Minimalabstände müssen die üblichen prozeßbedingten Verjustierungstoleranzen auffangen. Die Feldoxidkanten müssen ihrerseits wieder einen Minimalabstand zur Gateelektrode einhalten, so daß insgesamt beträchtliche Abstände zustande kommen. Insgesamt resultieren daraus große Chipflächen und hohe Zuleitungswiderstände, und große parasitäre Zuleitungskapazitäten.

Zur Lösung dieser Problematik sind bereits verschiedene Ansätze bekannt. So sollen insbesondere in periodischen Strukturen von Speicherfeldern die Kontakte durch selbstjustierte Techniken realisiert werden. Diese Technik ist unter dem Stichwort "Fully overlapping bit line contact" bekannt. In einem anderen Ansatz wird ein Überlapp von Kontaktloch über die Feldoxidkante zugelassen, wobei anschließend die Kontaktbereiche implantiert werden. Für diesen Ansatz ist jedoch mindestens eine Zusatzfototechnik erforderlich und das Problem der Dotierstoffaktivierung muß gelöst werden.

Es sind auch anisotrope Ätzverfahren entwickelt worden, die Oxid selektiv zu Nitrid ätzen können. Mit diesen Ätzverfahren ist es möglich, Kontaktlochätzungen selbstjustiert zu vorher strukturierten Nitridbereichen durchzuführen. Allerdings ist es schwierig, eine derart hohe Selektivität zu erreichen, was zur Folge hat, daß die maximale Tiefe derart hergestellter Kontakte begrenzt ist.

Der Erfindung liegt die **Aufgabe** zugrunde, eine CMOS-Halbleiterstruktur der eingangs genannten Art zu schaffen, an der auf besonders einfache Weise selbstjustierte Kontaktlochätzungen durchgeführt werden können. Außerdem soll ein Verfahren der eingangs genannten Art zur Herstellung einer solchen CMOS-Halbleiterstruktur geschaffen werden.

Zur Lösung der Aufgabe wird eine CMOS-Halbleiterstruktur vorgeschlagen, die sich dadurch auszeichnet, daß über den Feldplatten eine Nitridschicht angeordnet ist, die Feldplatten an ihren seitlichen Begrenzungen von einer dielektrischen Abdeckung geschützt sind und die Nitridschicht über den Feldplatten und die dielektrische Abdeckung an den seitlichen Begrenzungen der Feldplatten eine durchgehende Ummantelung bilden.
Dadurch wird eine besonders kleine Halbleiterstruktur geschaffen und das Problem der Ätzselektivität zwischen Oxid und Nitrid bei der selbstjustierten Kontaktlochätzung reduziert.

Verfahrensmäßig wird die Aufgabe dadurch gelöst, daß auf einem Substrat ein Gateoxid erzeugt wird, eine Polysiliziumschicht, eine Nitridschicht und eine Oxidschicht abgeschieden werden und eine durch eine Fototechnik maskierte anisotrope Ätzung bis zum Gateoxid durchgeführt wird, aus der Polysiliziumschicht gebildete Feldplatten durch eine isotrope Ätzung lateral rückgeätzt werden, eine dielektrische Schicht konform abgeschieden und damit der rückgeätzte Feldplattenbereich gefüllt wird und die dielektrische Schicht durch eine isotrope Ätzung außerhalb der rückgeätzten Feldplattenbereiche entfernt wird.
Mit diesem Verfahren kann die erfindungsgemäße CMOS-Halbleiterstruktur erzeugt werden, bei der eine dielektrische Schicht, insbesondere eine Nitridschicht ausgebildet wird, die eine dünne Feldplattenschicht vollständig umschließt und so eine selbstjustierte Kontaktlochätzung ohne Probleme mit der Ätzselektivität möglich macht.

Die dielektrische Abdeckung an den seitlichen Begrenzungen der Feldplatten besteht bevorzugt aus Nitrid. Dadurch besteht die gesamte Ummantelung aus der über den Feldplatten liegenden Schicht und den seitlichen Begrenzungen der Feldplatten aus Nitrid und kann einheitlich bearbeitet werden.

In einer anderen bevorzugten Ausführungsform der Erfindung besteht die dielektrische Abdeckung an den seitlichen Begrenzungen der Feldplatten aus TEOS (Tetra Ethyl Ortho Silikat). Bei Verwendung einer TEOS-Schicht wird im Verlauf des Verfahrens, genauer gesagt im letzten Schritt des erfindungsgemäßen Verfahrens, auch das Gateoxid entfernt.

Die Dicke der Nitrid-Ummantelung im Kontaktlochbereich ist bevorzugt etwas größer als die Dicke der Feldplattenschicht von typischerweise weniger als 100 nm, so daß auch mit geringer Ätzselektivität eine sichere Maskierung durch die Nitrid-Ummantelung gewährleistet werden kann.

Nachfolgend wird die Erfindung anhand eines in der Zeichnung erläuterten Ausführungsbeispiels weiter erläutert. Im einzelnen zeigen die schematischen Darstellungen in
- Fig. 1 bis 4: Querschnitte durch einen aktiven Bereich einer CMOS-Halbleiterstruktur bei verschiedenen Verfahrensständen, und
- Fig. 5 und 6: Querschnitte durch einen Kontaktlochbereich einer CMOS-Halbleiterstruktur bei verschiedenen Verfahrensständen.

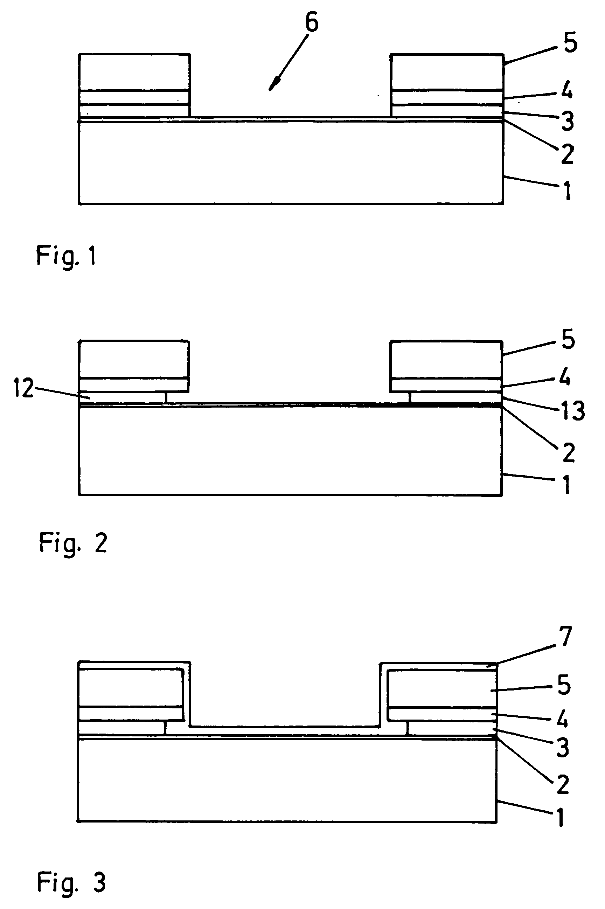

Ein Verfahren zur Herstellung der erfindungsgemäßen CMOS-Halbleiterstruktur wird im folgenden anhand der schematischen Figuren beschrieben. Auf eine unstrukturierte Halbleiteroberfläche, ein Substrat 1, wird ein erstes Gateoxid 2 durch Abschaltung oder thermische Oxidation aufgebracht und mit einer Polysiliziumschicht 3, die zur Herstellung der Feldplatten dient, abgedeckt. Auf diese Feldplattenschicht wird eine Nitridschicht 4 aufgebracht. Auf diese Nitridschicht 4 wird die eigentliche Feldoxidschicht 5 aufgebracht. Mit einer ersten Fototechnik wird dieser gesamte Isolationsstack anisotrop bis herunter zur ersten Gateoxidschicht 2 geätzt, um einen aktiven Bereich 6 zu definieren. Dieser Verfahrensstand ist in Figur 1 dargestellt.

Nach dem Entfernen der Ätzpolymere wird nun erfindungsgemäß die Polysiliziumschicht 3, die auch als Feldplattenschicht bezeichnet wird, durch eine isotrope Ätzung lateral zurückgeätzt. Dadurch entsteht der in Figur 2 dargestellte Überhang der Nitridschicht 4 und der Feldoxidschicht 5 über die Feldplatten 12 und 13.

In Figur 3 ist dargestellt, wie mit einer zweiten sehr konformen Nitridabscheidung eine Nitridschicht 7, oder allgemeiner eine zweite Dielektrikumschicht, aufgebracht wird und nahezu beliebige Konturen erfüllt und insbesondere den rückgeätzten Bereich der Feldplattenschicht auffüllt.

Durch eine isotrope Nitridätzung, die hoch selektiv zu Oxid ist, wird die zweite Nitridschicht 7 außerhalb der Seitenflächen der Feldplattenbereiche wieder entfernt. Damit ist eine vollständige Verkapselung der Feldplattenbereiche gegeben, ohne in den aktiven Bereichen 6 das erste Gateoxid 2 vollständig zu entfernen. Wird für die zweite Dielektrikumschicht anstelle von Nitrid TEOS verwendet, so wird im Zuge der isotropen Ätzung auch das erst Gateoxid 2 entfernt, so daß der nachfolgend für die Verwendung von Nitrid beschriebene Ätzschritt entfallen kann. Auf diese Weise wird neben der auf den Feldplatten 12, 13 liegenden Nitridschicht 4 eine seitliche dielektrische Abdeckung 14 geschaffen.

Im aktiven Bereich 6 wird nun das verbliebene erste Gateoxid 2 entfernt und das eigentliche Gateoxid 8 hergestellt. Dieses wird in den aktiven Bereichen 6 durch Abscheidung von Polysilizium zur Herstellung einer Gateelektrode 9 abgedeckt. Der Herstellungsprozeß wird in üblicher Weise mit Gatestrukturierung, Herstellung der Source- und Drainanschlüsse und Aufbringen eines Planarisierungsoxides 10 fortgesetzt.

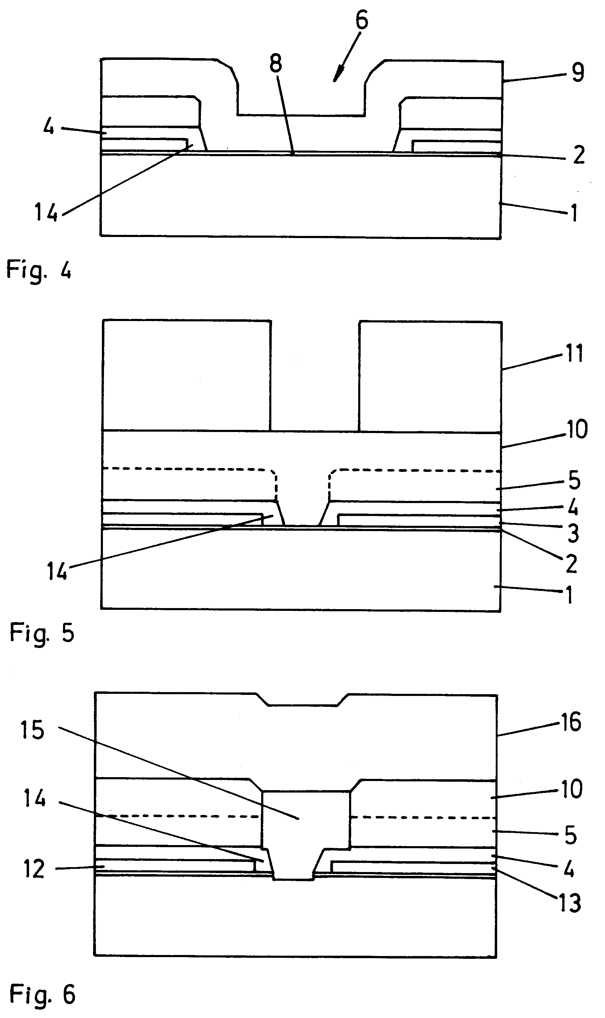

Die Herstellung der Kontaktlöcher ist in den Figuren 5 und 6 dargestellt. Die Ausbildung der Ummantelung der Polysiliziumschicht 3, bzw. der Feldplattenbereiche, wird in den Kontaktlochbereichen parallel und analog zu der Ummantelung in den aktiven Bereichen 6 durchgeführt. Die Kontaktlöcher werden dann mit einer Fototechnik hergestellt, wobei Überlappungen und Verjustierungen zu den Feldisolationsbereichen zugelassen sind. Mit einer Lackmaske 11 wird das Planarisierungsoxid 10 anisotrop geätzt. Sobald die Ätzung bis zur Nitridverkapselung vorgedrungen ist, wird sie dort maskiert, während die Ätzung in den Kontaktbereichen das Substrat freilegt. Die Anätzung der maskierenden Nitridschicht 4 ist in Figur 6 schematisch angedeutet. Die Schichtdicke, insbesondere des lateralen Anteils der Verkapselung muß so gewählt sein, daß bei gegebener Ätzselektivität und verbleibender Ätzzeit auch nach der üblichen Kontaktlochnachbehandlung die Nitridschicht 4 ausreichend dick bleibt, so daß bei Anliegen der Betriebsspannung kein Leckstrompfad zwischen Kontaktlochmetall und Feldplattenbereich entsteht. Die Kontaktlochauffüllung 15 und die erste Metallebene 16 werden nach bekannten Verfahren hergestellt.

### Bezugszeichenliste

- 1: Substrat
- 2: erstes Gateoxid
- 3: Polysiliziumschicht
- 4: Nitridschicht
- 5: Feldoxidschicht
- 6: aktiver Bereich
- 7: zweite Nitridschicht
- 8: zweites Gateoxid
- 9: Gateelektrode
- 10: Planarisierungsoxid
- 11: Lackmaske
- 12: Feldplatten
- 13: Feldplatten
- 14: dielektrische Abdeckung
- 15: Kontaktlochauffüllung
- 16: erste Metallebene

## Patentansprüche

1. CMOS-Halbleiterstruktur mit einem Substrat (1), einem Gateoxid (2), einer darüberliegenden Polysiliziumschicht (3) zur Bildung von Feldplatten (12, 13), und weiteren darüberliegenden isolierenden Schichten, insbesondere einer Oxidschicht (5),
**dadurch gekennzeichnet**,
daß über den Feldplatten (12, 13) eine Nitridschicht (4) angeordnet ist,
daß die Feldplatten (12, 13) an ihren seitlichen Begrenzungen von einer dielektrischen Abdeckung (14) geschützt sind und
daß die Nitridschicht (4) über den Feldplatten (12, 13) und die dielektrische Abdeckung (14) an den seitlichen Begrenzungen der Feldplatten eine durchgehende Ummantelung bilden.

2. CMOS-Halbleiterstruktur nach Anspruch 1,
**dadurch gekennzeichnet**,
daß die dielektrische Abdeckung (14) aus Nitrid besteht.

3. CMOS-Halbleiterstruktur nach Anspruch 1,
**dadurch gekennzeichnet**,
daß die dielektrische Abdeckung (14) aus TEOS besteht.

4. CMOS-Halbleiterstruktur nach einem der vorhergehende Ansprüche,
**dadurch gekennzeichnet**,
daß die durchgehende Ummantelung etwas dicker ist als die Dicke der Feldplatten.

5. Verfahren zur Herstellung einer CMOS-Halbleiterstruktur nach einem der Ansprüche 1 bis 4,
bei dem auf einem Substrat ein Gateoxid erzeugt wird, eine Polysiliziumschicht, eine Nitridschicht und eine Oxidschicht abgeschieden werden und eine durch eine Fototechnik maskierte anisotrope Ätzung bis zum Gateoxid durchgeführt wird,
**dadurch gekennzeichnet**,
daß aus der Polisiliziumschicht gebildete Feldplatten durch eine isotrope Ätzung lateral rückgeätzt werden,
daß eine dielektrische Schicht konform abgeschieden und damit der rückgeätzte Feldplattenbereich gefüllt wird und
daß die dielektrische Schicht durch eine isotrope Ätzung außerhalb der rückgeätzten Feldplattenbereiche entfernt wird.
